# EUROPEAN PATENT SPECIFICATION

(11) **EP 0 344 367 B1**
(45) Date of publication and mention of the grant of the patent: **24.08.1994**
(21) Application number: 88304003.2
(22) Date of filing: 03.05.1988
(51) Int. Cl.: G02F 1/01, G02F 1/19, G02F 1/167

(54) **Monolithic flat panel display apparatus**
Monolithische Flachtafel-Anzeigevorrichtung
Appareil monolithique d'affichage à tableau

(43) Date of publication of application: 06.12.1989
(73) Proprietor: COPYTELE INC., Huntington Station New York 11746 (US)
(72) Inventor: Disanto, Frank J., North Hill, NY 11040 (US); Krusos, Denis A., Lloyd Harbor, NY 11743 (US)
(74) Representative: Beresford, Keith Denis Lewis

(56) References cited:
- EP-A- 0 062 289
- EP-A- 0 202 705
- GB-A- 2 122 013
- GB-A- 2 151 834
- GB-A- 2 166 899
- US-A- 4 742 345
- SID INTERNATIONAL SYMPOSIUM DIGEST OF TECHNICAL PAPERS, first edition, May 1985, pages 124-127, Palisades Institute for Research Services, Inc., New York, US; W.A. CROSSLAND et al.: "An electrically addressed smectic storage device"

## Description

This invention relates to monolithic flat panel display apparatus. More particularly, it relates to the large number of finely spaced conductors present in electro optical display apparatus. In an embodiment of the invention, these conductors are metallized to allow driver circuitry to be wire bounded thereto.

The difficulty of providing a large number of connections to finely spaced conductors has become legend with respect to large scale integrated circuits (LSI) and even more pronounced with respect to very large scale integrated circuit devices (VLSI). Difficulties there encountered become even more extreme when one considers the connection requirements associated with the fabrication of monolithic flat panel display apparatus such as electrophoretic display panels.

In devices of this type such as described in U.S. Application Serial No. 670,571, now U.S. Patent No. 4,655,897, as entitled "Electrophoretic Display Panels and Associated Methods" as filed on November 13, 1984 in the names of Frank J. DiSanto, Sr. and Denis A. Krusos, the inventors herein, and assigned to the assignee herein, as well as in U.S. Application Serial No. 799,458, now U.S. Patent No. 4,742,345, entitled "Electrophoretic Display Panel Apparatus and Methods Therefor" as filed on November 19, 1985 in the names of the instant inventors and assigned to the present assignee, resolution of 200 lines per 25mm (1 inch) is obtained in a display having a conductor density of 200 lines per 25mm (1 inch) in each of the row and column directions. Thus, in a typical display having dimensions which correspond to the typical dimensions of a 216mm (8½ inch) by 279mm (11 inch) sheet of paper 2200 row conductors and 1700 vertically disposed column conductors would be utilized. Each conductor in the 2200 by 1700 conductor matrix formed requires connection to driver circuitry and resolution surpassing more than 200 lines per 25mm (1 inch) is envisioned.

The row and column conductors of such displays are typically etched upon the glass layer forming the display as such fine line patterns are not available through the use of other techniques. When the display is assembled, each of the 2200 row conductors and 1700 column conductors are brought out to the periphery of the panel formed where connection is typically made to driver circuits for selectively energizing the rows and columns to form patterns in accordance with data to be displayed. Typically, individual driver circuits in the form of integrated circuits are employed to drive a designated group of conductors from the periphery of the column and row. In this vein a typical driver circuit is capable of driving 64 individual conductors where the driver circuit receives 10 inputs provided by electronics external to the electrophoretic panel.

Connection to the driver circuits at the periphery of the electrophoretic panel is preferably achieved during the fabrication of the panel since alignment problems can occur due to the conductor densities involved. In such an arrangement each group of 64 row and column conductors may be specially configured at the periphery of the display to accommodate connection to specific driver chips; however, the entire assembly process is time consuming and costly. The assembly process also is typically subject to alignment errors and is often attended by reliability problems.

One technique for achieving suitable connection of the row and column conductors present in a high resolution electrophoretic display is set forth in U.S. Patent No. 4,598,960 which is entitled "Methods and Apparatus for Connecting Closely Spaced Large Conductor Arrays Employing Multiconductor Carrier Boards" and issued on July 8, 1986 to the inventors herein and is commonly assigned. According to the techniques described in U.S. Patent No. 4,598,960 a driver circuit in the form of an integrated circuit is mounted on a carrier board. The driver circuit interconnects with 64 etched output conductors on the carrier board as well as 10 input conductors. The carrier board is specially configured through the use of data apertures to align with correspondingly grouped row or column conductors of the electrophoretic display under such circumstances that the data apertures are aligned with mounting posts mated to the base plate of the assembly and insure appropriate alignment of the carrier boards. Connection of the carrier board outputs to the row and column conductors within the electrophoretic display is mechanically achieved through the use of Zebra connectors and this same technique is employed to provide connection to the inputs of the carrier board. Connection of the carrier board to the integrated circuit is achieved through wire bonding techniques and the entire assembly once fabricated is clamped in place to assure that once appropriate mechanical and electrical alignment is achieved the same will be retained.

While the techniques set forth n U.S. Patent No. 4,598,960 are effective, they are subject to a number of difficulties and result in a display assembly which is complex, costly to fabricate, and subject to a number of reliability problems both during initial fabrication and after periods of use. For example, the ceramic carrier boards employed are costly and the data apertures provided therein must be accurate within 2.5um (one ten thousandth of an inch) or else alignment problems may result. In addition, assembly of the complex structure is time consuming which increases manufacturing costs and the mechanical connections achieved with the Zebra connectors can be subject to reliability problems in the presence of substantial vibration as can the clamps employed.

The article by W.A. Crossland et al entitled "An electrically addressed smectic storage device" (SID International Symposium Digest of Technical Papers, first edition, May 1985, pages 124-127) discloses a method of making external connections to a liquid crystal flat panel display. In order to eliminate the need to make 1200 external connections to the panel, the TAB (tape automated bonding) on glass method of assembly is used. Methods of metallizing the base indium tin oxide were used which allowed solder reflow attachment of the chips and provided high conductivity of tracks for power distribution. The manner in which chips were attached along the edges of the liquid crystal panel is shown in Fig. 4 of the article.

The present invention has been made with the above difficulties in mind.

In accordance with a first aspect of the invention, there is provided a monolithic flat panel display apparatus comprising:
an insulating substrate (2);
a flat panel display area (4) provided on a surface of said insulating substrate, this including a multiplicity of closely spaced conductors (8, 6) arranged in columns and rows, these being mutually insulated and defining addressable picture element intersections;
interconnective metallized conductor portions (26-36) arranged about the periphery of said flat panel display area (4) without crossing another, these being coextensive with each of the column and row conductors (8, 6) for providing interconnection between each of the column and row conductors (8, 6) and receiving areas (80) which are arranged to receive respective column and row driver integrated circuits (12₁-12ₙ, 10₁-10ₙ) which receiving areas (80) each have first, second, third and fourth sides (88, 90, 92, 94), the first and second sides (90, 94) being substantially parallel to each other and having a length longer than that of the third and fourth sides (88, 92) and which are spaced apart around the periphery of said flat panel display area (4), said interconnective metallized conductor portions (26-36) being arranged in spatial groups, the conductor portions of each group terminating along three edges of a respective receiving area; and
input/output signal lines, (14, 16) including a strobe signal line, arranged about the periphery of said interconnective conductor portions (26-36), these lines being parallel to each other and to respective edges of said flat panel display area (4);
which display apparatus is characterised in that:
said flat panel display area (4) is an electrophoretic display panel in which the column and row conductors have a high density, typically 80 lines/cm (200 lines/in), each receiving area (80) is arranged with said first and second sides (90, 94) substantially transverse to the side of the display area (4) nearest that receiving area (80), the conductor portions (26-36) of each group terminate along the first and second sides and along a third side (92) which is the side of the receiving area (80) closest to the nearest side of the display area (4); and
said conductor portions of each group, which portions terminate along said first and second sides, extend outwards from said respective receiving area in a direction transverse to said first or second side, bend towards said display area (4) to extend in a direction parallel to said first or second side, the bends of conductor portions extending from each said first or second side lying on a respective slant line and a majority of said conductor portions bend towards the center of said group to extend in a direction transverse to said first or second side, and again bend toward said display area (4) to extend in a direction parallel to said first or second side, the locii of these bends lying on respective slant lines.

Optional features are set out in claims 2 to 11.

Embodiments of the present invention provide improved monolithic flat panel display apparatus.

Embodiment of the invention provide electrophoretic display apparatus wherein row and column driver circuits are directly bonded to the display panel and connected to individual conductors therein through use of wire bonding techniques.

Embodiments of the present invention provide electrophoretic display apparatus wherein portions of the row and column conductors are patterned and metallized to permit the same to be directly bonded to driver circuits.

In a display according to an embodiment of the present invention, the end portions of the row and column conductors of a display panel are metallized, grouped and patterned to accept a driver circuit within the pattern of each group; the driver circuit is then bonded to the panel and each output of the driver circuit to be employed is wirebonded to the patterned conductor portions within the group associated therewith; inputs to the driver circuit may also be wire bonded to input conductors provided on the panel to provide an integral one piece structure.

The invention will be more clearly understood by reference to the following detailed description of an exemplary embodiment thereof in conjunction with the accompanying drawings in which:
FIG. 1 is a pictorial view illustrating a portion of a preferred embodiment of monolithic flat panel display apparatus;
FIG. 2 is a front view, partially in section, illustrating a portion of the monolithic flat panel display apparatus shown in FIG. 1, depicting the manner in which end portions of row and column conductors may be metallized;
FIG. 3 is a top view illustrating the manner in which end portions of row or column conductors may be grouped and patterned for accepting a driver circuit; and
FIG. 4 is a top view illustrating the manner in which a driver circuit is mounted and connected to end portions of row or column conductors on a monolithic flat panel display.

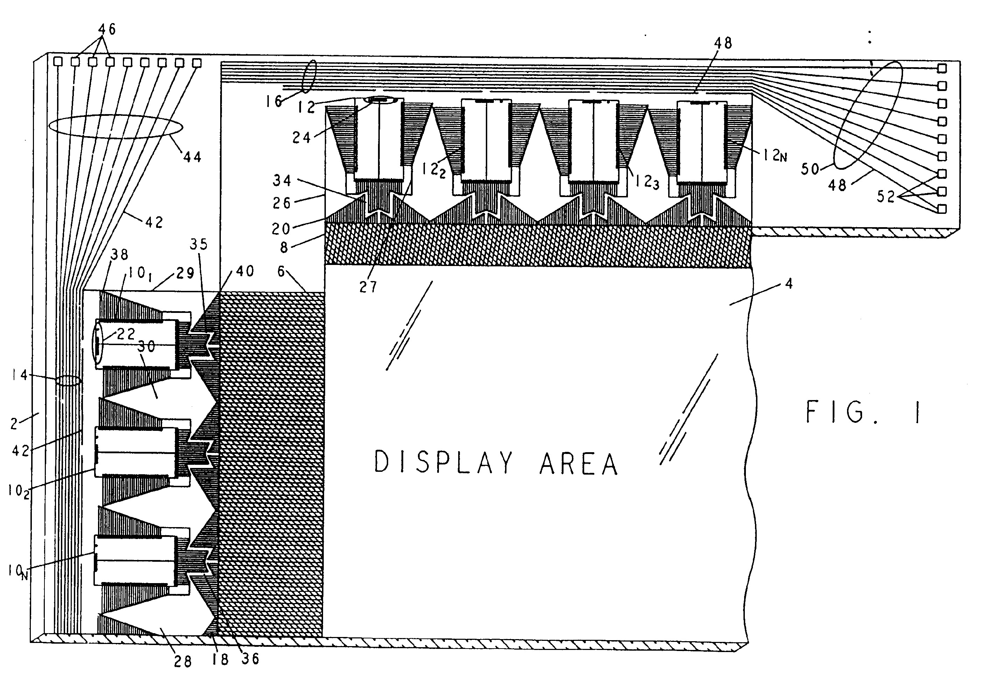

Referring now to the drawings and more particularly to FIG. 1 thereof, there is shown a pictorial view illustrating a portion of a preferred embodiment of monolithic flat panel display apparatus. More particularly, from what has been stated above, those of ordinary skill in the art will appreciate that a typical 216mm (8½ inch) by 279mm (11 inch) electrophoretic display exhibiting a resolution of 200 lines per 25mm (1 inch) will comprise some 2200 cathode or row conductors and some 1700 column or grid conductors together with an overlying anode structure. Therefore, in an effort to present an overall appreciation of the embodiment, only the upper left hand corner of such a display has been illustrated in FIG. 1, the left hand corner illustrated comprising approximately 192 row of cathode conductors and 256 column or grid conductors. Those of ordinary skill in the art will appreciate that the same may be treated as a complete display of reduced size or a portion of a larger display, it being understood that all that is required to extend the same to a full size 216mm (8½ inch) by 279mm (11 inch) display is an extension of what is illustrated in FIG. 1 in the row and column directions.

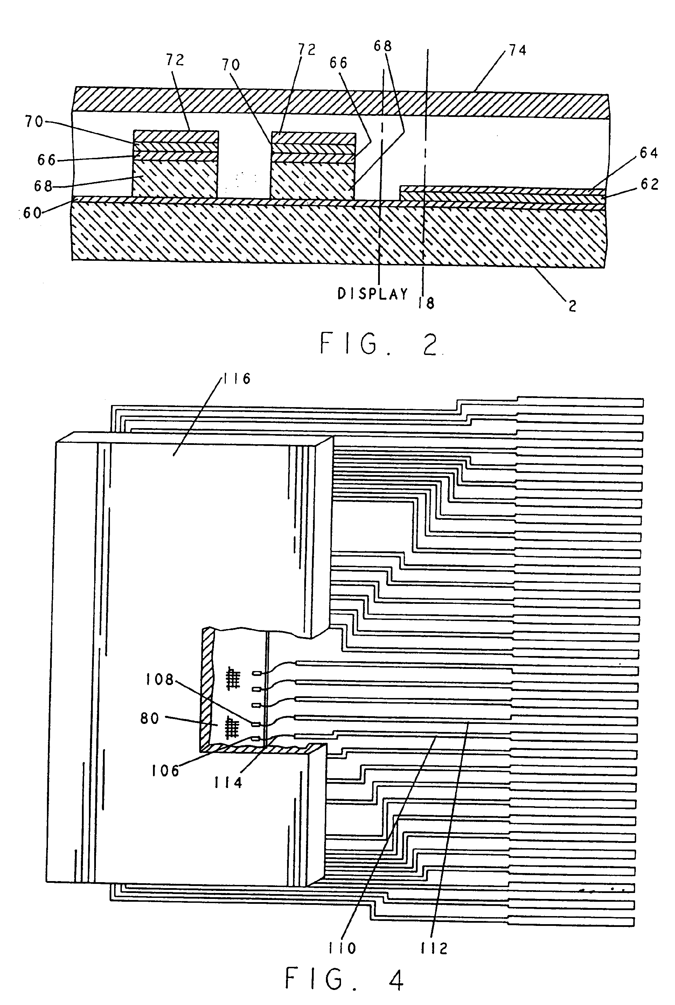

The portion of the preferred embodiment of the monolithic flat panel display apparatus illustrated in FIG. 1 comprises a glass panel or base plate 2 which, as shall be seen in connection with FIG. 2, is preferably coated with an extremely thin layer of indium-tin-oxide (ITO) as available as described in the aforesaid U.S. Patent Application Serial No. 670,571 (now U.S. Patent No. 4,655,897) from many suppliers. Although glass covered with indium-tin-oxide is preferred, other materials as commonly employed in electrophoretic displays or the like may be used for the base coating. As shall be seen below, the indium-tin-oxide is etched and portions thereof are metalized to form the column and row conductor structure and the drive lines depicted in FIG. 1. The coating of indium-tin-oxide on the glass plate 2 has a thickness which may typically range from 10 to 30nm (100 to 300 angstroms) and hence is transparent while yielding a conductor structure which may readily be etched in accordance with the teachings set forth in U.S. Patent Nos. 4,655,897 and/or 4,742,345 as aforesaid. The anode structure for the display illustrated in FIG. 1 is not shown.

The portion of the monolithic flat panel display apparatus illustrated in FIG. 1 comprises a display area 4, row conductors 6, column conductors 8, row driver circuits 10₁ - 10_{n'} column driver circuits 12₁ - 12ₙ and input drive lines 14 and 16 for the row and column driver circuits. The display area 4 is shown clear to assist in the depiction thereof, it being recognized that the same has a row and column conductor density of 200 lines per 25mm (1 inch) in each direction. In fact, while the cathode row conductors etched in the ITO layer in the manner described in U.S. Patent Nos. 4,655,897 and 4,742,345 have a density in the display area 4 of 200 lines per 25mm (1 inch), the column or grid conductors 8 formed in the display area will preferably have the 4 tined configuration described in detail in U.S. Patent No. 4,742,345. Hence actual conductor density in the display area in the column direction would be 800 lines per 25mm (1 inch).
Those of ordinary skill in the art will further appreciate that while the row or cathode conductors etched in the ITO are transparent, the column or grid conductors formed of metal, such as nickel or the like, in the manner described in U.S. Patent No. 4,742,345 are perceivable to a minor degree since a true metal cannot be made fully transparent even though the thickness of the same is extremely reduced. The display area 4 has been shown as clear in FIG. 1 for purposes of ease of illustration and understanding.

The row 6 and column 8 conductors are illustrated in FIG. 1 between the boundary lines 18 and 20 as extending to and from the display in the ungrouped manner in which the same reside within the display area in the horizontal and vertical directions. After the positions indicated by the boundary lines 18 and 20, the row and column conductors 6 and 8 are grouped and patterned to facilitate connection to the row and column driver circuits 10₁ - 10ₙ and 12₁ - 12ₙ. The boundary lines 18 and 20 also may be viewed as indicating the location of where metalizing of the row and column conductors in accordance with the present embodiment may terminate prior to entry of the row and column conductors 6 and 8 into the display area 4. However, as will be readily appreciated as the description herein proceeds, the location of the boundary lines 18 and 20 may vary to suit manufacturing and/or design convenience. While it is not the purpose of the instant disclosure to provide a description of the manner in which monolithic flat panel display apparatus, such as an electrophoretic display, operates those of ordinary skill in the art will appreciate that the display achieved within the display area 4 will be a function of the potential applied to predetermined ones of the row and column conductors 6 and 8 since the potential present at the various intersections of these conductors within the display area will cause a propagation of electrophoretic particles within the display area 4 to achieve the display pattern. A detailed understanding of the operation of electrophoretic displays of the type being described herein may be found in U.S. Patent Nos. 4,655,897 and 4,742,345 as aforesaid.

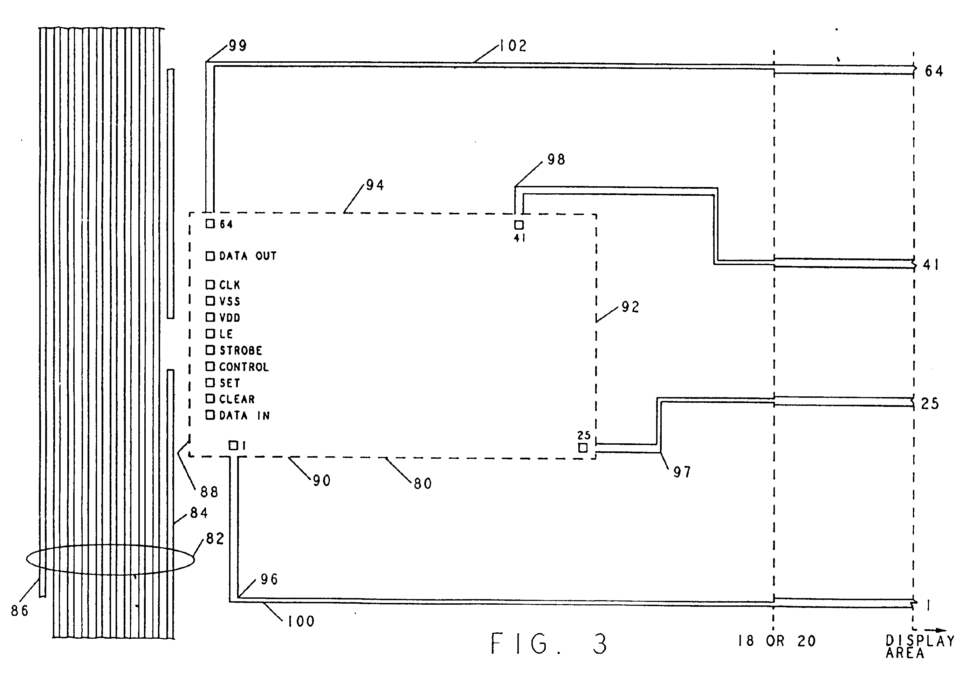

After the locations indicated by the boundary lines 18 and 20 each of the row and column conductors 6 and 8 within the display apparatus illustrated in FIG. 1 is metalized in a manner to be described in connection with FIG. 2 and grouped and patterned in a manner further described in connection with FIGS. 3 and 4 so as to facilitate connection to the row and column driver circuits 10₁ - 10ₙ and 12₁ - 12ₙ.

The row and column driver circuits 10₁ - 10ₙ and 12₁ - 12ₙ each comprise an integrated circuit chip of the type described in U.S. Patent No. 4,598,960 as aforesaid and perform the functions set forth in that patent as well as the functions described in somewhat greater detail in U.S. Patent No. 4,742,345. Each of the integrated circuits forming the row and column driver circuits 10₁ - 10ₙ and 12₁ - 12ₙ receives ten inputs as indicated generally to the rear of the row driver circuits 10₁ - 10ₙ and to the top of the column driver circuits 12₁ - 12ₙ and in response thereto selectively apply potential to each of the 64 outputs thereof to energize the 64 row and column conductors 6 and 8 connected to the outputs of each of the row driver circuits 10₁ - 10ₙ and column driver circuits 12₁ - 12ₙ.

The 64 outputs of each of the row and column driver circuits 10₁ - 10ₙ and 12₁ - 12ₙ are peripherally arranged about three sides of the integrated circuit as generally indicated in FIG. 1. In this regard, it should be noted that in FIG. 1 actual connections to the inputs and outputs of the row and column driver circuits 10₁ - 10ₙ and 12₁ - 12ₙ is not shown for purposes of clarity of illustration. However, the relationship between each of the inputs and outputs of a respective row 10₁ - 10ₙ and column 12₁ - 12ₙ driver chips is readily apparent. The details concerning the actual connection of each input and output of the integrated circuit driver chips will be described in connection with FIG. 4. Here it is sufficient to appreciate that each of the ten inputs to the row driver circuits 10₁ - 10ₙ as generally indicated as 22 in FIG. 1 are supplied from the input drive lines for the row as indicated by the conductors 14 while each of the inputs for the column drive circuits 12₁ - 12ₙ as generally indicated by 24 are connected to individual ones of the drive lines 16.

The outputs of each of the row and column conductor drive circuits 10₁ - 10ₙ and 12₁ - 12ₙ, are arranged about the periphery such that as better illustrated in connection with FIG. 3. 24 outputs, i.e. 1-24 and 41-64 are disposed at each side of the chip while the remaining 16 outputs are disposed along the side opposite to the inputs 22 and 24. This, as will be appreciated by those of ordinary skill in the art, maximizes the periphery of the integrated circuit chip from the standpoint of providing locations for discrete inputs and outputs.

Each group of 64 row conductors 6, and 64 column conductors 8 are metalized in a manner to be described in greater detail in connection with FIG. 2 in order to facilitate connection to the outputs of an associated one of the row and column driver circuits 10₁ - 10ₙ and 12₁ - 12ₙ by use of a wire bonding machine. This is done as connection to a conductor formed of ITO or the like is not readily available with a wire bonding machine and nickel, which is commonly employed for the column conductors 8, presents similar difficulties.

In addition to metalizing, each group of 64 conductors is patterned in a manner to be described in greater detail in connection with FIG. 3 to provide a location for the integrated circuit chip serving as the row or column driver circuit 10₁ - 10ₙ and 12₁ - 12ₙ and to dispose each of the 64 metalized conductors in the group at a location so that the same is proximate to an associated one of the 64 outputs on the row or column driver circuit 10₁ - 10ₙ and 12₁ - 12ₙ This is also described in greater detail in connection with FIGS. 3 and 4. Here, to facilitate representation, it should be noted that the arrow-like representations 26-30 and the chevron-like representations 32-36 represent groups of conductors as the detailed pattern employed is better shown in figures such as FIGS. 3 and 4 having less structure. Thus, here it is sufficient to appreciate that with respect to the arrow-like representations 26-30 and the chevron-like representations 32-36, individual row conductors should be viewed as entering a grouping at an edge disposed aslant thereof for entry into the generalized bundle of row and column conductors 6 and 8 shown between the display area and the boundary lines 18 and 20 and conversely leave the arrow-like representations 26-30 and the chevron-like representations 32-36 along other edges disposed aslant thereof for application toward an individual output of the driver chips 10₁ - 10ₙ and 12₁ - 12ₙ.

By way of example, an individual row conductor 40 may be viewed as entering the arrow-like representation 29 from the generalized row conductors 6 which enters the display area and leave the arrow-like representation 29 at the row conductor location 38 for connection to an output such as output 63 of the row driver circuit 10₁. Thus, this form of representation will serve to generally provide the reader with an overall understanding of the manner in which 64 row or column conductors are associated with each of the row and driver chips 10₁ - 10ₙ and 12₁ - 12ₙ and readily facilitates an understanding concerning the manner in which the illustration of the embodiment of the invention illustrated in FIG. 1 may be readily extended to accommodate a full 216mm (8½ inch) by 279mm (11 inch) electrophoretic display panel having 2200 row conductors and 1700 column conductors. In the case of a full scale display 35 row driver circuits 10₁ - 10ₙ and 27 column driver circuits 12₁ - 12ₙ arranged about the periphery of the glass panel or base plate 2 in precisely the same manner illustrated for the portion thereof shown in FIG. 1 would be employed.

The input driver lines 14 for each of the row driver circuits 10₁ - 10ₙ comprise 9 parallel conductors which are etched along the left side of the glass panel 2 in the manner illustrated in FIG. 1 to provide the ten requisite inputs for each of the row driver circuits 10₁ - 10ₙ. In this regard, those of ordinary skill in the art will appreciate, upon an inspection of FIG. 1, that drive line 42 within the group of 9 etched input drive lines 14 is split in the vicinity of each of the row driver circuits 10₁ - 10ₙ. This is done as the same represents the data-in and data-out drive line since each of the row driver chips 10₁ - 10ₙ are connected in series with respect to their data-in inputs and data-out outputs. Hence, the single drive line 42 within the group of 9 drive lines 14 for the row column drivers 10₁ - 10ₙ is split so that one side of this drive line may be connected to the data-in input of a given one of the row driver circuits 10₁ - 10ₙ while the opposite side is connected to the data-out output of that chip. The same side of the driver line 42 in turn is connected to the data-in input of the adjacent driver circuit chip affecting serial connection of the data-in and data outputs of each of the row driver chips 10₁ - 10ₙ in a manner well known to those of ordinary skill in the art.

Accordingly, the 9 input drive lines 14 effectively supply the 10 input/output connections for each of the row driver circuits 10₁ - 10ₙ, it being noted that additional drive lines may be etched within the group 14 should a different row driver circuit configuration be employed. Each of the 9 drive lines 14 within the input drive line group 14 is flared out in the manner indicated at 44 and provided with a contact pad 46 to facilitate connection to external circuitry in the manner well known to those of ordinary skill in the art.

In precisely the same manner, the input drive lines 16 are etched as a group of 9 drive lines to provide 10 input/output connections to the column driver circuits 12₁ - 12ₙ. Here, the input drive lines 16 are horizontally disposed along the periphery of the glass panel 2. The drive line 48 is again split in the vicinity of each of the column driver circuits 12₁ - 12ₙ to again facilitate the serial connection of the input of the data-in and data-out connections to each of the column driver circuits 12₁ - 12ₙ. As was also the case for the row input drive lines 14, the etched column drive lines 16 are flared out in the manner indicated at 50 toward the right end of the glass panel 2 and contact pads 52 are provided to facilitate connection to external drive circuitry. Those of ordinary skill in the art will readily appreciate that the flared out portion 50 of the etched column drive line 16 will preferably occur subsequent to the location of the last row driver circuit 12ₙ and hence in a display employing 27 column driver circuits 12₁ - 12ₙ the flared out portion of the drive lines 16 would in fact appear at the edge of the display in a comparable manner to that illustrated at 44 for the drive lines 14.

As shall be seen below, connection of each of the inputs and outputs to the row 10₁ - 10ₙ and column 12₁ - 12ₙ driver circuits to the row 6 and column conductors 8 as well as the input/output drive lines 14 and 16 are made by use of a wire bonding machine after the row 10₁ - 10ₙ and column 12₁ - 12ₙ driver circuit integrated circuits are epoxy or otherwise bonded to the glass panel or base plate 2. Thus, once the anode structure (not illustrated in FIG. 1) is mounted to the monolithic flat panel display apparatus illustrated in FIG. 1, an integral, one piece display not requiring mechanical assembly other than the mounting of the same within a suitable frame structure is achieved. Further, all electrical connections may be implemented through the use of wire bonding machines or the like to insure rapid assembly and the reliability which attends a structure not requiring mechanical connections of electrical contacts and the attendant clamping associated with such structures. Thus, when compared to the complex structure illustrated in FIG. 7 of U.S. Patent No. 4,598,960, it will be seen that little more than the electrophoretic panel 70 is required and the complete avoidance of expensive ceramic carrier boards and complex location thereof is achieved.

Referring now to FIG. 2 there is shown a front view, partially in section, illustrating a portion of the monolithic flat panel display apparatus shown in FIG. 1 depicting the manner in which end portions of row and column conductors may be metallized in an embodiment.
At the outset it should be noted that the structure of an electrophoretic display such as disclosed in U.S. Patent No. 4,742,345 is preferred as the tined column conductor structure thereof is viewed as highly advantageous and results in an enhanced display. Therefore, the description of FIG. 2 should be considered as if the tined column-grid structure set forth in U.S. No. 4,742,345 were being configured. However, those of ordinary skill in the art will appreciate that the concepts set forth within the instant disclosure are equally applicable to the form of electrophoretic display panels set forth in U.S. Patent No. 4,655,897 or to alternate structures thereof known to the prior art. Conversely, embodiments of the present invention are fully applicable in any application where a great many connections to closely spaced conductors are to be made and those conductors do not normally admit of wire bonding applications.

The portion of the monolithic flat panel display apparatus illustrated in FIG. 2 is a section selected to best illustrate the techniques for selectively metalizing portions of row and column conductors in an embodiment of the instant invention while essentially leaving the display area free of additional metalizing to retain the transparent nature thereof. For this reason, FIG. 2 has been deliberately drafted out of proportion with respect to FIG. 1 such that distance between the boundary line 18 illustrated in FIG. 1 and the actual beginning of the display area 4 is compressed in the manner indicated by the dashed line 18 and the dashed line annotated Display in FIG. 2. Hence, what is illustrated in FIG. 2 should be understood as depicting in cross section a portion of the glass plate 2 associated with row conductors 6 to the left of the boundary line 18 shown in FIG. 1, shown to the right of the dashed line 18 in FIG. 2 as well as portions of the display area involving the first few column conductors (shown to the left of the dashed line annotated Display in FIG. 2).

As described above, and in greater detail in U.S. Patent Nos. 4,655,897 and 4,742,345, a glass plate 2, preferably coated with an extremely thin layer of indium-tin-oxide (ITO) 60 as available from many suppliers, acts as a port through which a viewer of the display may discern image information set forth thereon. The ITO layer is extremely thin of the order of 10 to 30nm (100 to 300 angstroms) and hence is truly transparent. The row or cathode conductors 6 are formed within the ITO layer directly on the glass substrate 2 and, as shall be seen below, in the area of the display the row or cathode conductors 6 comprise only the ITO layer to insure that the transparency of the display area is retained. However, in areas external to the display and where contacts to the row or cathode conductors are to be made, these conductors are metalized by overcoating the same with one or more metallic layers characterized by their ability to accept wire bonding and to adhere to the ITO cathode conductors.

The actual configuration of the row and column conductors within the display area 4 is explained in great detail, together with the manner in which the same may be formed in U.S. Patent No. 4,742,345 whose disclosure is specifically incorporated by reference herein. Accordingly, should additional detail concerning the dimensions or techniques for forming the row and column conductors be desired, reference to that application is suggested.

The portion of the monolithic flat panel display apparatus illustrated in FIG. 2 comprises a glass plate 2 overcoated with a thin layer of indium-tin-oxide (ITO) 60. The ITO layer 60, as shall be seen below, is patterned to form row conductors forming the cathodes of the display which have a density, for example, of 200 lines per 25mm (1 inch). Thus, in the case of a 216mm (8-1/2 inch) wide by 279mm (11 inch) long display area 4 the pattern will be such that 2200 horizontally disposed cathode or row conductors will be etched in a manner to be described below in the row direction. Typically, as described in U.S. Patent No. 4,742,345, each of the row conductors formed will have a width of the order of 112um while separation between adjacent row conductors is typically 15um. This pattern will exist underlying the entire display area 4 and extending generally to the boundary line 18. After the boundary line 18 patterning of each of the row or cathode conductors is implemented in a manner best appreciated in connection with FIGS. 3 and 4. In addition, after boundary line 18 each ITO row conductor 60 in the portion of the panel outside of the display area 4 and essentially between the boundary line 18 and the periphery of the panel or glass plate 2 is overcoated with one or more metallic layers 62 and 64 patterned, in a manner to be described below, in precisely the same manner as the underlying ITO layer so that effectively the ITO layer outside of the display area 4 is metalized.

After the row or cathode conductors are formed and the peripheral portions of the ITO conductors are metalized in the manner indicated by the layers 62 and 64, column conductors 66 are formed underlying the display area in precisely the manner described in U.S. Patent No. 4,742,345, as aforesaid. In areas of the row conductors external to the display area 4, the row conductors are patterned in the manner best appreciated in connection with FIGS. 3 and 4. In FIG. 2 solid column conductors 66 and insulator 68, on which they reside, are illustrated as the cross section shown in FIG. 2 is through a section selected for purposes of showing peripheral portions of the column conductors 66 external to the display area 4 so that the metalizing associated therewith can be depicted. The column conductors 66, however, are preferably formed in the area of the display as multiple tined conductors of the type best illustrated in FIG. 4 of U.S. Patent No. 4,742,345 such that effectively 4 parallel tines form each column conductor in the area of the display. Under these conditions each of the 4 tines has a typical width of 20um and has an internal spacing between tines of 13um while the spacing between conductors is 15um. Portions of the photoresist pads 68 underlying each of the tines are similarly formed in parallel sections in a manner best illustrated in FIG. 3 of U.S. Patent No. 4,742,345.

The column conductors 66 are also metalized in peripheral portions of the panel external to the display area 4 as indicated by the layers 70 and 72. An anode structure 74 is provided in the manner described in connection with U.S. Patent No. 4,742,345, as aforesaid, and overlies at least portions of the display panel overlying the display area 4.

As was noted above, the glass panel or base plate 2 is typically obtained having a thin layer of ITO formed thereon as a transparent layer. The same then is configured in accordance with an embodiment of the instant invention by first patterning the ITO layer to form the row or cathode conductors 60 in the manner described in U.S. Patent No. 4,742,345. Thereafter the row conductors 60 may be entirely overcoated or peripherally disposed portions thereof outside of the display area 4 are selectively coated with one or more metallic layers 62 and 64. If the entire surface of the ITO row conductors are metalized, the portions of the layers 62 and 64 overlying the ITO row conductors in the display area 4 are then removed by sputter etching or similar wet etching techniques so that the metalized layers are removed in the area of the display enabling the transparent nature thereof to be retained.

Thereafter, the column conductors 66 on the insulating pads 68 are formed in precisely the manner described in association with U.S. Patent No. 4,742,345 as aforesaid. Once this is done, one or more metalized layers 70 and 72 for the column conductors 66 may be formed on peripheral portions of the column conductors. Alternatively, each of the column conductors 66 may be metalized in their entirety by the plating of one or more metallic layers 70 and 72 thereon. Again, portions of the metalizing layers 70 and 72 in the display area 4 may be removed through an etching process or here, the same may be left intact as the column conductors 66 which are typically formed of nickel are true metals and hence are not transparent regardless of the thickness involved.

If the approach of initially patterning the ITO layer by the formation of row or cathode conductors in the manner set forth in U.S. Patent No. 4,742,345 is followed, the patterning would be conducted in precisely the manner set forth in that application. Thereafter, the metalized layers 62 and 64 would be formed in such a manner that the layer 62 is selected of a metal which displays good adherence qualities to ITO layer 60 while the layer 64 is selected of a metal to which wire bonding may take place. Thus, if multiple layers 62 and 64 are employed, the layer 62 may comprise nickel, chrome or molybdenum while the layer 64 may typically comprise gold or aluminum. Alternatively, a single layer of aluminum or the like may be utilized. In other variations a three layer combination of molybdenum, gold and nickel may be utilized wherein the nickel or molybdenum layer is selected for overcoating on the ITO conductor 60 while the gold layer represents the top layer 64 to which wire bonding will take place.

A typical example of such technique would comprise the steps of initially patterning by forming the ITO image of the row or cathode conductors 60 in precisely the same manner set forth in U.S. Patent No. 4,742,345. Thereafter, approximately 2.5nm (10 millionths of an inch) of nickel would be plated on the ITO conductors formed. This would be followed by the plating of approximately 1nm (4 millionths of an inch) of gold on the nickel. Thereafter, the resulting structure would be baked at approximately 250°C for 30 minutes. This would be followed by the plating of approximately 10nm (40 millionths of an inch) of gold on the structure formed.

If the ITO row conductors in the display area 4 were metalized in the foregoing manner, rather than only being metalized in peripheral portions thereof, the display area 4 will be etched to remove the metalizing represented by layers 62 and 64 therefrom in the manner indicated in FIG. 2. This will be accomplished, as will be readily appreciated by those of ordinary skill in the art, by the use of a dry etch affected by way of sputter etching wherein the depth of the etch can be readily controlled. Alternately a wet etch wherein the specific materials, here gold and nickel, are selectively removed by use of commercially available etching solutions such as Aquarega for the gold and nickel etch for the nickel are employed.

Thereafter, the column conductors 66 and insulating pads 68 therefor are formed precisely in the manner described in U.S. Patent No. 4,742,345. The column conductor 66 would typically be formed of nickel as described in that U.S. Patent No. 4,742,345. Thereafter, these column conductors, which act as grids, are metalized by the formation of the layers 70 and 72 thereon. This may be done precisely in the manner described with respect to the formation of the layers 62 and 64. Alternatively, a chrome and gold combination may be employed for the layers 70 and 72 or again a single layer of aluminum may be utilized. If the entire length of the column conductor 66 is metalized, the metalizing material may again be removed from the area of the display 4 by using a dry or wet etch such as noted above or alternatively the metalized layers employed for the column or grid conductors may be left in place in the area of the display area since the column conductor 66 is formed of a true metal and will not be transparent. Therefore slightly increasing the thickness thereof due to the presence of the metalizing layers 70 and 72 will not adversely effect images formed in the display area 4.

Metalizing of the row and column conductors in the manner illustrated in FIG. 2 may be readily implemented by first patterning the row conductors 60 and thereafter selectively metalizing the conductors formed as described above. This will be followed by precisely the same procedure with respect to the column conductors 66. However, it has been found that it is generally more efficient to achieve the structure illustrated in FIG. 2 by first forming the composite layer structure and thereafter selectively patterning the same. This permits the entire structure of the rows to be formed by a singular photomask operation followed by a corresponding photomask procedure for the columns. Thus, using this approach, the glass plate 2 bearing the ITO layer 60 would first have metalizing layer 62 formed thereon using conventional sputtering or other well known deposition techniques. Thereafter a second layer 64 would be applied again employing conventional sputtering techniques or the like. Alternatively, a single layer of aluminum or chrome may replace both the layers 62 and 64, it being noted that while a single layer of gold could perform this function it is generally viewed as too soft to be used alone.

Once the ITO layer 60 is completely overcoated with the metalizing layer or layers 62 and 64, the same would be overcoated with a photoresistive layer of any conventional form. Thereafter a photo mask having the conductor pattern associated with the plurality of row conductors and having the end portions patterned in the manner described in connection with FIGS. 3 and 4, is placed on the photoresistive layer formed. The entire structure is then exposed to ultraviolet light through the mask and developed. Those of ordinary skill in the art will appreciate that what remains after the removal of the developed material will comprise the desired conductor pattern for the plurality of row conductors and end portions wherein each conductor will be overcoated with photoresistive material. The remaining portions of the composite metalized structure comprising layers 60, 62 and 64 will not be overcoated with photoresistive material. Once this is achieved the row structure may be etched using conventional etching techniques so that only the composite material comprising layers 60, 62 and 64 overcoated by photoresistive material which corresponds to the mask employed in the exposure step remains. Thereafter, the complete surface area of the glass plate 2 is again exposed to ultraviolet light without the benefit of the mask so that the overcoated photoresistive material on the row conductor pattern formed is now exposed. Upon development, this photoresistive material may be removed leaving the plurality of row conductors in the pattern of the mask formed on the glass plate 2.

Removal of the metalizing layers 62 and 64 on portions of the row conductors 60 in the display area 4 is then accomplished by conventional etching such as dry etching accomplished through the use of sputter etching techniques wherein the depth of the etch can be uniformly controlled. Alternatively, wet etching techniques may be utilized employing commercially available material selective etching liquids.

Once the plurality of row conductors, metalized in portions of the display external to the display area 4, have been formed, formation of the column conductors may take place. This is initiated, as will be appreciated by those of ordinary skill in the art, by overcoating the entire surface of the panel including the previously formed and metalized row conductors with a insulating material. Once the insulating material has been entirely overcoated on the surface of the glass plate 2 having the metalized column conductors formed thereon, the insulating layer is overcoated with a thin layer of nickel in the manner described in U.S. Patent No. 4,742,345. Alternatively, a thin layer of aluminum, which will not require further metalizing, may be employed.

Assuming, however, that nickel is utilized for the column conductors 66, the layers 70 and 72 are overcoated on the nickel in precisely the same manner described for the layers 62 and 64. Here it should be appreciated that since the complete surface is being overcoated a layer at a time sputtering techniques, such as use of planar magnitrons or the like, may be readily employed. Once the thin layers 66, 70 and 72 are overcoated on the insulating layer 68, a photoresistive layer (not shown) is formed over the top metalizing layer 72 which may be gold. The structure of the layers 66, 70 and 72 may be nickel, chrome and gold; nickel, molybdenum and gold; nickel, chrome and aluminum; nickel, molybdenum and aluminum; or, alternatively, a single aluminum layer may replace the three layers 66, 70 and 72.

Once this sandwich-like structure is formed, a photoresistive layer (not shown) is formed over the top layer 72 to enable the plurality of vertically disposed column or grid conductors to be formed through conventional etching techniques. Thus, a mask corresponding to the pattern of the column conductors in the tine arrangement described in U.S. Patent No. 4,742,345 and having the end portions patterned in the manner described in connection with FIGS. 3 and 4 is placed over the photoresist and the photoresist is exposed to ultraviolet light. Thereafter, the photoresist is developed enabling the removal of the photoresist from portions of the surface in which the initial layer of photoresist 68 and nickel layer 66 and the metalized layers 70 and 72 are not to be retained.

After the exposed and developed portions of the top layer of photoresist material (not shown) is removed, the exposed metal areas are etched to yield the resulting structure shown in FIG. 2 except that the conductor 72 will be overcoated by a layer of photoresist material which has not yet been exposed. The etching procedure is precisely as described in U.S. Patent No. 4,742,345. Thereafter, the resulting structure is again exposed to ultraviolet light so that the photoresistive material overlying layer 72 may be developed and removed. Once this has been achieved, the metalizing layers 70 and 72 overlying the display area 4 maybe selectively etched so as to only leave the metalizing layers 70 and 72 in the peripheral portions of the panel formed outside of the boundary line 18. Alternatively, in the case of the column conductors 66, the metalizing layers 70 and 72 may be left in the display area 4 since the column conductors 66 are not transparent.

Referring now to FIG. 3 there is shown a top view illustrating the manner in which end portions of row and column conductors are grouped and patterned for accepting a driver circuit. More particularly, each group of 64 row and column conductors in the monolithic flat panel display illustrated in FIG. 1 is arranged and patterned in the manner illustrated in FIG. 3 so as to accept and subsequently be connected to an associated row or column driver circuit 10₁ - 10ₙ or 12₁ - 12ₙ. Those of ordinary skill in the art will appreciate that in the case of a 216mm (8½ inch) by 279mm (11 inch) display having approximately 2200 row conductors and 1700 column conductors, 35 groupings for row driver circuits 10₁ - 10ₙ would be present while 27 column groupings for column driver circuits 12₁ - 12ₙ would be present. Each grouping formed would be identical to that illustrated in FIG. 3. In FIG. 3 an exemplary row or column driver circuit has been indicated by the dashed block 80 to illustrate the outline of the driver chip per se and exemplary outputs 1, 25, 41 and 64 have been illustrated, together with the 10 I/O connections thereto. An associated input/output drive line array 82, corresponding to an appropriate one of the input/output drive line arrays 14 and 16 illustrated in FIG. 1 has also been indicated in FIG. 3.

The 9 conductor I/O drive line array 82 is etched at the peripheral portion of the array as indicated in FIG. 1 so as to provide 9 parallel conductors in the manner illustrated in FIG. 3. The closest conductor 84 to the chip location 80 is split so as to provide for the serial connection of each row or column driver to the single split line to obtain the serial connection of the data-in and data-out outputs of each chip, as aforesaid. While not illustrated in FIG. 3 the split conductor 84 may be somewhat thickened with respect to the remaining conductors within the I/O drive line array 82 to facilitate test probing of the input and output signals. Although any convenient spacing and arrangement maybe employed for the I/O drive line array 82, a convenient arrangement for embodiments of the instant invention which have been built and tested, is to provide an I/O drive line array wherein each conductor has a typical width of 0.25mm (0.010 inch) and is spaced from the adjacent conductor within the array by a distance of 0.025mm (0.001 inch). The initial conductor in the array, i.e. conductor 86, is typically disposed 4.65mm (0.1832 inch) from the edge of the glass plate 2 and the distance allotted between the edge of the last conductor 84 in the array and the rear edge 88 of the row or column driver 80 is 0.25mm (0.010 inch). The I/O drive line array 82 may be printed on the glass plate employing conventional photomask techniques such as described above with respect to the formation of the row and column drivers.

The row or column driver 80 which may be conventional will have nominal dimensions of 6.17mm (0.2428 inch) by 3.68mm (0.1448 inch) with the shorter dimension obviously located along the edge 88 illustrated in FIG. 3. The specific input/output connections to and from this chip as provided in the I/O drive line array 82 are specifically indicated as disposed near the edge of the chip 88 and have been annotated with their function to render their character apparent. Those of ordinary skill in the art will appreciate the specific nature of the inputs and outputs provided on the driver chip 80 may be varied to suit the choice of the designer.

The location of the initial and end output pads on each of the remaining three sides 90, 92 and 94 of the driver chip 80 are indicated while the boundary lines 18 and 20 illustrated in FIG. 1 have also been indicated by way of the dashed line annotated 18 or 20 in FIG. 3. Although only 4 exemplary conductors have been shown in FIG. 3, the interrelationship in the patterning among the conductors in each 64 conductor group may be appreciated upon an inspection of FIG. 4 which shows an exemplary grouping of conductors.

As will be seen upon an inspection of FIG. 3, each of the 64 conductors to be connected to a specific driver chip 80 is brought out from the display area having the same width as was employed in the display area. In this case this width corresponds to approximately 0.08mm (0.0033 inches), although spacing may vary from 112 to 115um. In the case of the four tine column conductors described in U.S. Patent No. 4,742,345 each of the four tines of a specific conductor are joined into a single column conductor subsequent to its leaving the display area and for this purpose, if desired, slightly enlarged pad areas may be employed. Thus, until the location indicated by the boundary line 18 or 20 the width of each conductor is retained at that employed in the display area.

After the boundary area indicated by the dashed line 18 or 20, the width of each of the 64 row or column conductors within a specific group is thinned by approximately one half to a typical thickness of 0.04mm (0.0015 inch) to facilitate the patterning illustrated in FIGS. 3 and 4 and brought to a location 96-99 where it is directly opposite to the pad 1, 25, 41, 64 on the row or column driver 80 to which connection is to be affected. At this location, the conductor is again thickened in the manner indicated in FIGS. 3 and 4 so as to have a width which corresponds to the approximate 0.1mm (4 mil) width of each of the pads 1, 25, 41 and 64 of the row or column driver chip 80. Thus, in configuring the mask the 0.11mm (4.25 mil) width of each row or driver conductor brought out from the display area to the boundary line 18 or 20 is first reduced to a width of 0.04mm (1 and 1/2 mils) to facilitate patterning. Thereafter once the same is brought opposite to the pad on the driver chip 80 to which connection is to be made the width is expanded to 0.1mm (4 mils) so as to correspond in width of the connection pad on the driver chip 80. The patterning of each of the 64 conductors to be connected to an individual row or driver chip 80 may be achieved through conventional photomask techniques such as described in connection with the formation of the row and driver conductors. As indicated in FIG. 3, each of the 64 row or driver conductors once patterned is brought to a location indicated by the dashed edges 90, 92 and 94 of the row or driver chip 80 which essentially corresponds to where that edge will reside once the row or column driver 80 is mounted in the array being formed.

The distance between the edge of the driver chip 92 and the boundary line 18 or 20 may typically be 3.25mm (0.128 inch). The distance from the edges 90 and 94 of the driver chip 80 to the outer edges of the conductors 100 and 102, the conductors connected to outputs 1 and 64 of the driver chip 80, may typically be 2.2mm (0.08675 inch). Thus, it will be seen that the 64 row or column conductors grouped for connection to a particular row or column driver chip 80 are patterned in the manner illustrated in FIG. 3 and further shown in FIG. 4 so as to provide a location for the row or column driver chip 80 per se as indicated by the dashed lines 88, 90, 92 and 94 in FIG. 3 and to bring each of the conductors to a location opposite its connection pad at a width corresponding to the pad width of the output on the row or column driver 80 to which it is to be connected. Further, the thinning of the conductor width between the location indicated by the boundary line 18 or 20 and its location opposite to the pad to which it is to be connected readily facilitates the patterning being conducted. This can readily be achieved through the use of the same photomask techniques described in connection with the formation of the row and column drivers.

Once the entire conductor structure for the monolithic flat panel display apparatus illustrated in FIG. 1 is formed in the manner described in connection with FIGS. 2 and 3, the actual row and column drivers 10-1 - 10ₙ and 12-1 - 12ₙ are mounted on the panel formed. More particularly, through the use of a conventional chip mounting machine, each of the row and driver chips 10₁ - 10ₙ and 12₁ - 12ₙ have a small spot of low temperature thermal setting epoxy or similar adhesive placed on the bottom thereof and the same are positioned again through the use of a chip mounting machine or the like within the outline provided as indicated by the dashed lines 88, 90, 92 and 94 in FIG. 3. Once all of the row and column driver chips 10₁ - 10ₙ and 12₁ - 12ₙ are properly positioned in the location indicated by the dashed lines 88, 90, 92 and 94 in FIG. 3 on the array, the entire panel is placed in an oven set at a temperature of approximately 120°C for approximately 2 hours to allow the epoxy bond formed intermediate the bottom surface of the row or column driver chip 80 and the display panel to cure.

Once this has been completed, actual connection of each of the 64 row or column conductors in a group is made to each of the 64 outputs of the row or column driver chip 80 and each of the 10 input/outputs at the rear of the chip along the edge 88 is connected to associated ones of the conductors within the I/O drive line array 82. The manner in which this is achieved is best appreciated in connection with FIG. 4.

Referring now to FIG. 4 there is shown a top view illustrating the manner in which a driver circuit is mounted and connected to end portions of the patterned row or column conductors within a group of 64 conductors in the monolithic flat panel display apparatus according to an embodiment of the instant invention. More particularly, as shown in FIG. 4, the row or column driver circuit 80, once epoxied or otherwise adhered to the glass panel or base plate 2, must have each of the contact pads 106 and 108 on the top surface thereof connected to associated ones of the row or column conductors 110 or 112, in the manner indicated in FIG. 4. To achieve this function, the entire monolithic panel formed is placed in a wire bonding machine so that each of the pads 106 and 108 may be connected to corresponding conductors 110 and 112. The wire bonding machine is loaded with gold or aluminum wire and the wire bonding machine is set up for an appropriate ultrasonic bonding cycle. Thereafter, connection is typically initiated at the pad 106 or 108 on the driver chip, the preferred loop in the wire 114 is set and thereafter bonding to a conductor 110 occurs.

This process is continued by the operator from one contact pad 106 or 108 to the next until each of the 74 contact pads on the driver circuit 80 is connected wherein outputs 1-64 are connected to the 64 grouped row or column conductors associated with the display area while the 10 inputs to the driver circuit are connected to respective ones of the conductors within the I/O drive line array 82. If a manual wire bonding machine is employed, this operation will take 10 to 15 minutes per driver chip 80. However, if an automatic wire bonding machine is utilized, once setup has been established, bonding of the 74 contact pads to appropriate conductors will occur at a rate of approximately one chip each nine seconds. The scrubbing cycle for the vibrator is typically set to approximately 40 milliseconds in the bonding operation being carried out.

Further, since the pad and matching conductor widths are approximately 0.1mm (4 mils), the connection operation is well within the precision of most conventional wire bonding machines since connection within 0.025mm (1 mil) of center is sufficiently accurate for purposes of embodiments of the instant invention. Once an entire driver chip has been interconnected to its inputs and outputs as described above, a protective cover 116, as illustrated in FIG. 4, is placed over the driver circuit 80 to protect the circuit per se and each of the wire bonds made to the pads thereof. The cover 116 may be formed of ceramic or epoxy material.

Thus, those of ordinary skill in the art will appreciate that embodiments of the instant invention allow wire bonding techniques to be employed to secure an integrated monolithic structure which is highly simplified and readily admits of large scale integrated circuit processing techniques despite the highly complex nature thereof. Further, this occurs despite the fact that ITO is typically employed as a conductive, transparent layer from which cathode grid conductors are formed.

Although the instant invention has been described in connection with a highly specific exemplary embodiment thereof, it will be understood that many modifications and variations, particularly with regard to dimension, will occur to those of ordinary skill in the art. Therefore, it is manifestly intended that this invention be only limited by the claims.

## Claims

1. A monolithic flat panel display apparatus comprising:
an insulating substrate (2);
a flat panel display area (4) provided on a surface of said insulating substrate, this including a multiplicity of closely spaced conductors (8,6) arranged in columns and rows, these being mutually insulated and defining addressable picture element intersections;
interconnective metallized conductor portions (26-36) arranged about the periphery of said flat panel display area (4) without crossing another, these being coextensive with each of the column and row conductors (8,6) for providing interconnection between each of the column and row conductors (8,6) and receiving areas (80) which are arranged to receive respective column and row driver integrated circuits (12₁-12ₙ, 10₁-10ₙ) which receiving areas (80) each have first, second, third and fourth sides (88, 90, 92, 94), the first and second sides (90,94) being substantially parallel to each other and having a length longer than that of the third and fourth sides (88, 92), and which are spaced apart around the periphery of said flat panel display area (4), said interconnective metallized conductor portions (26-36) being arranged in spatial groups, the conductor portions of each group terminating along three edges of a respective receiving area; and
input/output signal lines, (14,16) including a strobe signal line, arranged about the periphery of said interconnective conductor portions (26-36), these lines being parallel to each other and to respective edges of said flat panel display area (4);
which display apparatus is characterised in that:
said flat panel display area (4) is an electrophoretic display panel in which the column and row conductors have a high density, typically 80 lines/cm (200 lines/in), each receiving area (80) is arranged with said first and second sides (90, 94) substantially transverse to the side of the display area (4) nearest that receiving area (80), the conductor portions (26-36) of each group terminate along the first and second sides and along a third side (92) which is the side of the receiving area (80) closest to the nearest side of the display area (4); and
said conductor portions of each group, which portions terminate along said first and second sides, extend outwards from said respective receiving area in a direction transverse to said first or second side, bend towards said display area (4) to extend in a direction parallel to said first or second side, the bends of conductor portions extending from each said first or second side lying on a respective slant line with respect to said sides, and a majority of said conductor portions bend towards the center of said group to extend in a direction transverse to said first or second side, and again bend toward said display area (4) to extend in a direction parallel to said first or second side, the locii of these bends lying on respective slant lines.

2. Apparatus as claimed in claim 1 further including said respective column and row driver integrated circuits (12₁-12ₙ, 10₁-10ₙ) adhered to said substrate (2) within each respective receiving area.

3. Apparatus as claimed in claim 2 wherein wire bond connections (114) provide connection between said interconnective metallized conductor portions (26-36, 110, 112) and each output drive pad (106,108) of each respective driver integrated circuit (12₁-12ₙ, 10₁-10ₙ) and between respective selected ones of said signal lines (14,16) and each respective driver integrated circuit (12₁-12ₙ, 10₁-10ₙ).

4. Apparatus as claimed in either of claims 2 or 3 wherein said respective column and row driver integrated circuits (12₁-12ₙ, 10₁-10ₙ) are adhered to said substrate (2) by means of thermosetting epoxy.

5. Apparatus as claimed in any one of the preceding claims wherein said multiplicity of closely spaced conductors (8,6) arranged in at least one of columns or rows are substantially transparent and are of indium tin oxide (ITO).

6. Apparatus as claimed in claim 5 wherein the metallized conductor portions coextensive with the closely spaced conductors each forming a cathode of the flat panel display, are of indium tin oxide and have an aluminium metallisation.

7. Apparatus as claimed in claim 5 wherein metallized conductor portions coextensive with the closely spaced conductors of indium tin oxide also are of indium tin oxide and have a gold metallisation.

8. Apparatus as claimed in claim 7 wherein said metallized conductor portions of indium tin oxide and gold include one of nickel, molybdenum and chrome between said indium tin oxide and said gold.

9. Apparatus as claimed in claim 5 wherein said multiplicity of closely spaced conductors (8,6) arranged in one of columns or rows are substantially transparent and are of indium tin oxide (ITO) and said multiplicity of closely spaced conductors (6,8) arranged in the other of rows or columns are of nickel.

10. Apparatus as claimed in claim 9 wherein said conductors of nickel each have the form of a metallized grid.

11. Apparatus as claimed in claim 10 wherein metallized conductor portions coextensive with said conductors of nickel also are of nickel and have a metallization of one of chrome, aluminium and gold.

## Patentansprüche

1. Monolitische Flachtafelanzeigevorrichtung, umfassend:
ein isolierendes Substrat (2);
einen Flachtafel-Anzeigebereich (4), der auf einer Fläche des isolierenden Subtrats vorgesehen ist, die eine Mehrzahl dicht beabstandeter, in Spalten und Reihen angeordneter Leiter (6, 8) enthält, die voneinander isoliert sind und addressierbare Bildelementschnittstellen definieren;
metallisierte Verbindungsleiterabschnitte (26 - 36), die kreuzungsfrei am Umfang des Flachtafel-Anzeigebereiches (4) angeordnet sind und als Fortsetzung zu jedem der Spalten- und Reihenleiter (8, 6) für eine Verbindung zwischen jedem der Spalten- und Reihenleiter (8, 6) und Aufnahmebereichen (80) sorgen, welche zur Aufnahme jeweiliger integrierter Spalten- und Reihen-Treiberschaltungen (12₁ - 12ₙ, 10₁ - 10ₙ) ausgebildet sind, die jeweils eine erste, eine zweite, eine dritte und eine vierte Seite (88, 90, 92, 94) aufweisen, von denen die erste und die zweite Seite (90, 94) im wesentlichen parallel zueinander verlaufen und eine Länge besitzen, die größer ist als diejenige der dritten und der vierten Seite (88, 92), und die entlang dem Umfang des Flachtafel-Anzeigebereiches (4) mit Abstand voneinander angeordnet sind, wobei die metallisierten Verbindungsleiterabschnitte (26 - 36) in räumlichen Gruppen angeordnet sind, während jeweilige Leiterabschnitte entlang dreier Ränder eines zugehörigen Aufnahmebereiches endet; und
Eingangs-/Ausgangssignalleitungen (14, 16) mit einer Strobe-Signalleitung am Umfang der Verbindungsleiterabschnitte (26 - 36), wobei diese Leitungen parallel zueinander und zu zugehörigen Rändern des Flachtafel-Anzeigebereiches (4) verlaufen;
**dadurch gekennzeichnet**, daß
der Flachtafel-Anzeigebereich (4) eine elektrophoretische Anzeigetafel ist, in welcher die Spalten- und Reihenleiter mit hoher Dichte von typischerweise 80 Leitungen/cm (200 Leitungen/Zoll) aufweisen, jeder Aufnahmebereich (80) mit der ersten und der zweiten Seite (90, 94) im wesentlichen quer zu der dem Aufnahmebereich (80) am nächsten liegenden Seite des Anzeigebereiches (4) angeordnet ist, die Leiterabschnitte (26 - 36) jeder Gruppe entlang der ersten und der zweiten Seite sowie entlang einer dritten Seite (92) enden, bei der es sich um die Seite des Aufnahmebereiches (80) handelt, die der nächstgelegenen Seite des Anzeigebereiches (4) am nächsten liegt; und
diejenigen Leiterabschnitte jeder Gruppe, die entlang der ersten und der zweiten Seite enden, sich von dem zugehörigen Aufnahmebereich in einer Richtung quer zu der ersten bzw. der zweiten Seite nach außen erstrecken, in Richtung auf den Anzeigebereich (4) abbiegen, um sich in einer Richtung parallel zu der ersten bzw. der zweiten Seite zu erstrecken, wobei die Abbiegungen der Leiterabschnitte, die sich von jeder ersten bzw. zweiten Seite aus erstrecken, auf einer zugehörigen schrägen Linie bezüglich der Seiten liegen, und eine Mehrheit der Leiterabschnitte in Richtung der Mitte der Gruppe abbiegt, um sich in einer Richtung quer zu der ersten bzw. der zweiten Seite zu erstrecken, um erneut in Richtung auf den Anzeigebereich (4) abzubiegen, so daß sie sich in einer Richtung parallel zu der ersten bzw. der zweiten Seite erstrecken, wobei die Orte dieser Biegungen auf zugehörigen Schräglinien liegen.

2. Vorrichtung nach Anspruch 1, **gekennzeichnet durch** jeweilige integrierte Spalten- und Reihentreiberschaltungen (12₁ - 12ₙ, 10₁ - 10ₙ), die innerhalb eines jeweiligen Aufnahmebereiches an dem Substrat (2) haften.

3. Vorrichtung nach Anspruch 2, bei dem Drahtbondverbindungen (114) für eine Verbindung zwischen den metallisierten Verbindungsleiterabschnitten (26, 36, 110, 112) und einem zugehörigen Ausgangstreiberkissen (106, 108) der zugehörigen integrierten Treiberschaltung (12₁ - 12ₙ, 10₁ - 10ₙ) sowie zwischen ausgewählten Signalleitungen (14, 16) und der zugehörigen integrierten Treiberschaltung (12₁ - 12ₙ, 10₁ - 10ₙ) sorgen.

4. Vorrichtung nach Anspruch 2 oder 3, bei der die jeweiligen integrierten Spalten- und Reihentreiberschaltungen (12₁ - 12ₙ, 10₁ - 10ₙ) mit Hilfe eines hitzeerhärtbaren Epoxymaterials an dem Substrat (2) haften.

5. Vorrichtung nach jedem der vorhergehenden Ansprüche, bei der die Vielzahl von eng beabstandeten Leitern (8, 6), die in mindestens einer der Spalten oder Reihen angeordnet sind, im wesentlichen transparent ist und aus Indium-Zinn-Oxid (ITO) besteht.

6. Vorrichtung nach Anspruch 5, bei der die metallisierten Leiterabschnitte, die eine Verlängerung bezüglich der eng beabstandeten, jeweils eine Kathode der Flachtafelanzeige bildenden Leiter darstellen, aus Indium-Zinn-Oxid bestehen und eine Aluminium-Metallisierung besitzen.

7. Vorrichtung nach Anspruch 5, bei der sich zusammen mit den eng benachbarten Leitern aus Indium-Zinn-Oxid metallisierte Leiterabschnitte erstrecken, die ebenfalls aus Indium-Zinn-Oxid bestehen und eine Gold-Metallisierung aufweisen.

8. Vorrichtung nach Anspruch 7, bei der die metallisierten Leiterabschnitte aus Indium-Zinn-Oxid und Gold zwischen dem Indium-Zinn-Oxid und dem Gold einen der Stoffe Nickel, Molybdän und Chrom enthalten.

9. Vorrichtung nach Anspruch 5, bei der die Vielzahl von eng beabstandeten Leitern (8, 6), die entweder in den Spalten oder in den Reihen angeordnet sind, im wesentlichen transparent ist und aus Indium-Zinn-Oxid (ITO) besteht, während die Vielzahl von eng beabstandeten Leitern (6, 8), die in den Reihen bzw. in den Spalten angeordneten sind, aus Nickel besteht.

10. Vorrichtung nach Anspruch 9, bei der die Leiter aus Nickel jeweils die Form eines metallisierten Gitters besitzen.

11. Vorrichtung nach Anspruch 10, bei der die metallisierten Leiterabschnitte, die sich gemeinsam mit den Leitern aus Nickel erstrecken, ebenfalls aus Nickel bestehen und eine Metallisierung aus einem der Stoffe Chrom, Aluminium und Gold aufweisen.

## Revendications

1. Dispositif d'affichage monolithique à panneau plat comprenant un substrat isolant (2) ;
une zone d'affichage à panneau plat (4) prévue sur une surface dudit substrat isolant, cette zone comprenant une multiplicité de conducteurs (8, 6) espacés d'étroits intervalles, disposés en colonnes et en rangées, ces dernières étant isolées les unes des autres et définissant des intersections adressables représentant des éléments d'images ;
des parties métallisées connectrices (26-36) de conducteurs disposées le long de la périphérie de ladite zone d'affichage (4) du panneau plat sans se croiser mutuellement, ces parties étant en coïncidence avec chacun des conducteurs (8,6) de colonnes et de rangées pour établir une interconnexion entre chacun des conducteurs (8, 6) de colonnes et de rangées, et des zones réceptrices (80) qui sont agencées pour recevoir des circuits intégrés respectifs (12₁-12ₙ, 10₁-10ₙ) d'attaque de colonnes et de rangées, lesquelles zones réceptrices (80) ont chacune des premier, deuxième, troisième et quatrième côtés (88, 90, 92, 94), les premier et deuxième côtés (90, 94) étant sensiblement parallèles entre eux et ayant une longueur supérieure à celle des troisième et quatrième côtés (88, 92), et lesquelles zones réceptrices sont espacées sur le tour de la périphérie de ladite zone d'affichage (4) du panneau plat, lesdites parties métallisées connectrices (26-36) de conducteurs étant agencées en groupes spatiaux, les parties de conducteurs de chaque groupe se terminant le long de trois côtés d'une zone réceptrice respective ; et
des lignes de signaux d'entrée/sortie (14, 16) comprenant une ligne de signaux de fixation, disposées le long de la périphérie desdites parties connectrices (26-36) de conducteurs, ces lignes étant parallèles entre elles et parallèles aux bords respectifs de ladite zone d'affichage (4) du panneau plat ;
lequel dispositif d'affichage est caractérisé en ce que
ladite zone d'affichage (4) du panneau plat est un panneau d'affichage électrophorétique dans lequel les conducteurs des colonnes et rangées ont une haute densité, typiquement de 80 lignes/cm (200 lignes/pouces), chaque zone réceptrice (80) est agencée de façon que lesdits premier et deuxième côtés (90, 94) soient sensiblement transversaux au côté de la zone d'affichage (4) le plus proche de cette zone réceptrice (80), les parties (26-36) de conducteurs de chaque groupe se terminent le long des premier et deuxième côtés et le long d'un troisième côté (92) qui est le côté de la zone réceptrice (80) le plus rapproché du côté le plus proche de la zone d'affichage (4) ; et
lesdites parties de conducteurs de chaque groupe, qui se terminent le long desdits premier et deuxième côtés, sortent de ladite zone réceptrice respective, dans une direction transversale audit premier côté ou audit deuxième côté, se coudent vers ladite zone d'affichage (4) pour s'étendre dans une direction parallèle audit premier côté ou audit deuxième côté, les coudes des parties des conducteurs partant de chaque premier côté ou de chaque deuxième côté qui se trouve sur une ligne respective inclinée par rapport auxdits côtés, et une majorité desdites parties des conducteurs se coudent vers le centre dudit groupe pour s'étendre dans une direction transversale audit premier côté ou audit deuxième côté et se coudent de nouveau vers ladite zone d'affichage (4) pour s'étendre dans une direction parallèle audit premier côté ou audit deuxième côté, les lieux géométriques de ces coudes se trouvant sur des lignes inclinées respectives.

2. Dispositif selon la revendication 1, dans lequel, en outre lesdits circuits intégrés (12₁-12ₙ, 10₁-10ₙ) d'attaque des colonnes et des rangées respectivement sont collés audit substrat (2) dans chaque zone réceptrice respective.

3. Dispositif selon la revendication 2, dans lequel des connexions (114) à fil soudé établissent la connexion entre lesdites parties métallisées connectrices (26-36, 110,112) des conducteurs et chaque plot d'attaque de sortie (106, 108) de chaque circuit intégré d'attaque respectif (12₁-12ₙ, 10₁-10ₙ) et entre des lignes sélectionnées respectives parmi lesdites lignes de signaux (14, 16) et chaque circuit intégré d'attaque (12₁-12ₙ, 10₁-10ₙ) respectif.

4. Dispositif selon l'une ou l'autre des revendications 2 et 3, dans lequel lesdits circuits intégrés d'attaque respectifs (12₁-12ₙ, 10₁-10ₙ) de colonnes et de rangées respectivement, sont collés audit substrat (2) au moyen d'un époxy thermodurcissable.

5. Dispositif selon une quelconque des revendications précédentes, dans lequel ladite multiplicité de conducteurs (8, 6) espacés d'étroits intervalles disposés dans au moins une des colonnes ou rangées sont pratiquement transparents et sont faits d'oxyde d'indium-étain (ITO).

6. Dispositif selon la revendication 5, dans lequel lesdites parties métallisées des conducteurs qui sont en coïncidence avec les conducteurs espacés d'étroits intervalles dont chacun forme une cathode de l'affichage à panneau plat sont faits d'oxyde d'indium-étain et portent une métallisation faite d'aluminium.

7. Dispositif selon la revendication 5, dans lequel les parties métallisées des conducteurs qui sont en coïncidence avec les conducteurs espacés d'étroits intervalles en oxyde d'indium-étain sont elles-aussi faites d'oxyde d'indium-étain et portent une métallisation d'or.

8. Dispositif selon la revendication 7, dans lequel lesdites parties métallisées des conducteurs en oxyde d'indium-étain et d'or comprennent un des métaux, nickel, molybdène et chrome entre ledit oxyde d'indium-étain et ledit or.

9. Dispositif selon la revendication 5, dans lequel ladite multiplicité de conducteurs (8, 6) espacés d'étroits intervalles disposés dans l'une des colonnes ou rangées sont pratiquement transparents et sont faits d'oxyde d'indium-étain (ITO) et ladite multiplicité de conducteurs espacés d'étroits intervalles (6, 8) disposés dans l'autre des rangées ou colonnes sont faits de nickel.

10. Dispositif selon la revendication 9, dans lequel lesdits conducteurs en nickel ont chacun la forme d'une grille métallisée.

11. Dispositif selon la revendication 10, dans lequel des parties métallisées des conducteurs qui sont en coïncidence avec les conducteurs en nickel sont aussi faites de nickel et ont une métallisation de l'un des métaux chrome, aluminium et or.
